# EUROPÄISCHE PATENTSCHRIFT

(11) **EP 2 928 659 B1**
(45) Veröffentlichungstag und Bekanntmachung des Hinweises auf die Patenterteilung: **07.02.2018**
(21) Anmeldenummer: 13828801.4
(22) Anmeldetag: 05.12.2013
(51) Int. Cl.: B29C 43/00, B29D 99/00, C04B 28/26, F28F 21/04

(54) **VERFAHREN ZUR HERSTELLUNG EINES FORMTEILS**
METHOD FOR PRODUCING A MOULDED PART
PROCÉDÉ DE FABRICATION D'UNE PIÈCE MOULÉE

(30) Priorität: 05.12.2012 EP 12195623
(43) Veröffentlichungstag der Anmeldung: 14.10.2015
(73) Patentinhaber: Zehnder Group International AG, 5722 Gränichen (CH); Götz, Thomas, 8266 Steckborn (CH); Kleiner, Wolfgang, 8266 Steckborn (CH)
(72) Erfinder: GÖTZ, Thomas, 88709 Hagnau (DE); KLEINER, Wolfgang, 88213 Ravensburg (DE)
(74) Vertreter: Rausch Wanischeck-Bergmann Brinkmann
(86) Internationale Anmeldenummer: PCT/IB2013/002701
(87) Internationale Veröffentlichungsnummer: WO 2014/087223

(56) Entgegenhaltungen:
- EP-A1- 0 004 882
- EP-A1- 0 028 341
- EP-A1- 0 524 403
- CH-A- 479 043
- CN-A- 1 560 287
- DE-A1- 2 636 430
- DE-A1- 4 204 583
- DE-A1- 4 411 436
- DE-A1- 10 060 875
- DE-A1- 10 310 803
- DE-A1- 19 651 721
- DE-A1- 19 738 373
- DE-B- 1 025 107
- DE-C- 576 509
- DE-C- 691 507
- DE-C- 727 872
- DE-C- 758 959
- GB-A- 168 025

## Beschreibung

Die Erfindung betrifft ein Verfahren zur Herstellung eines Formteils, insbesondere eines plattenförmigen Formteils.

Die Herstellung von Formteilen im Allgemeinen sowie von plattenförmigen Formteilen im Speziellen ist aus dem Stand der Technik an sich bekannt.

Die DE 196 51 721 A1 beschreibt ein Verfahren zur Herstellung eines Formkörpers aus metallhaltigem Abfallkonglomerat. Insbesondere metallhaltige Abfallstoffe wie zum Beispiel Metallspäne können hierbei per Zusatz eines viskositätssteigenden Stoffes wie zum Beispiel Wasserglas zu Formkörpern verpresst werden.

Die CN 1 560 287 A beschreibt einen Pressling, der aus Stahl- bzw. Eisenspänen hergestellt ist, wie sie bei der Stahlschlackenaufbereitung als Abfallmaterial anfallen: Besagter Pressling kann bis zu 5 % Wasserglas enthalten.

Die DE 44 11 636 A1 offenbart ein Wärmedämmformteil, welches aus Wasserglas und Aluminiumoxidstaub besteht. Als weitere Zusätze können Metallfasern zugegeben werden.

Die GB 168 025 A beschreibt ein Verfahren zur Brikettierung von Eisenspänen zur Verwendung in Hochöfen. Hierbei werden Eisenspäne und Wasserglas miteinander vermischt und abschließend in die gewünschte Brikettform gepresst.

Die DE 727 872 C offenbart verschiedene Formstücke bestehend aus Ligninfasern, Metallfasern sowie Wasserglas und werden durch abschließendes Pressen in die gewünschte Form gebracht.

Die Einsatz- und Verwendungsgebiete von Formteilen, auch von solchen in plattenförmiger Ausgestaltung sind zahlreich, weshalb es bezogen auf den jeweiligen Anwendungsfall unterschiedliche Anforderungen seitens der Formteile zu erfüllen gilt, was sich auch im Herstellungsverfahren niederschlägt. So sind aus dem Stand der Technik beispielsweise Formteile aus Kunststoff oder anderen gieß- oder stampf- oder pressbaren Materialien bekannt geworden, die zur Strukturverstärkung Gitternetze aus z.B. Metall- oder Glasfasern aufweisen. Aufgrund ihrer Materialkombination können derlei Formteile unterschiedlichen Anforderungen in der Verwendung gleichermaßen gerecht werden.

Obgleich Formteile sowie Verfahren zu deren Herstellung in vielerlei Ausgestaltungsformen aus dem Stand der Technik bekannt sind, besteht ein ständiges Bestreben nach weiter optimierten Herstellverfahren und/oder Formteilen. Nicht zuletzt spielt der Umweltschutz in diesem Zusammenhang eine immer wichtigere Rolle.

Es ist deshalb die **Aufgabe** der Erfindung, ein neuartiges Verfahren zur Herstellung eines Formteils vorzuschlagen, das bei gleichzeitiger Umweltfreundlichkeit eine einfache Verfahrensabwicklung gestattet.

Verfahrensseitig wird zur **Lösung** dieser Aufgabe vorgeschlagen ein Verfahren mit den Merkmalen des Patentanspruches 1. Weitere Vorteile und Merkmale ergeben sich aus den Unteransprüchen.

Nach dem erfindungsgemäßen Verfahren dient zur Herstellung eines Formteils ein Kompositwerkstoff, d.h. ein Verbundwerkstoff. Bei diesem Kompositwerkstoff handelt es sich erfindungsgemäß um einen Metall-Kompositwerkstoff, der Metallspäne und Wasserglas beinhaltet. Dabei dient das Wasserglas als Klebstoff für die Metallspäne. Dem Kompositwerkstoff ist ein Hydrophobierungsmittel beigemischt, welches erfindungsgemäß wenigstens eines aus der Gruppe Silane oder Siloxane aufweist.

Zur Herstellung des Kompositwerkstoffes werden die Metallspäne und das Wasserglas in einem vorgebbaren Mischungsverhältnis miteinander vermischt. Zwischen den Metallspänen und dem Wasserglas kommt es zu einer Reaktion in Form einer Diffusionsverklebung, wobei eine Verklebung des Wasserglases mit den Oxidschichten der Metallspäne stattfindet. Das Metall-Komposit wird sodann in eine Pressform eingebracht und zu einem Formteil verpresst.

Im endfertig verpressten Zustand weist das Formteil durch die bei der Verpressung des Metall-Komposits erfolgte Verformung und Verkrallung der einzelnen Metallspäne eine Basisstruktur mit sehr hoher Festigkeit auf, die sich ergänzend zur schon vorbeschriebenen Diffusionsverklebung einstellt. Im Ergebnis ergeben sich so Formteile von hoher mechanischer Festigkeit bei gleichzeitig geringem Gewicht, die darüber hinaus mechanisch nachbearbeitet werden können, wie z.B. durch Drehen, Bohren, Fräsen und/oder dgl.

Die Verwendung einer Pressform gestattet es, auch vergleichsweise komplizierte Geometrien ausbilden zu können. Dies gestattet auch die Ausgestaltung passgenauer Formteile. Im einfachsten Fall wird die Pressform durch die Pressflächen einer Flächenpresse gebildet. Diese dient der Herstellung plattenförmiger Formteile, wobei es gestattet ist, plattenförmige Formteile unterschiedlicher Wandstärken herzustellen. Zu diesem Zweck wird eine entsprechende Menge an Metall-Komposit zwischen die Pressflächen der Flächenpresse eingebracht, und es erfolgt durch entsprechendes Verfahren der Pressenflächen ein Verpressen des Metall-Komposits zu einem plattenförmigen Formteil, d.h. einer Platte.

Von Vorteil der erfindungsgemäßen Verfahrensdurchführung ist im Übrigen, dass die Ausgangskomponenten zur Herstellung des Kompositwerkstoffes in ausreichender Menge verfügbar und vergleichsweise preiswert am Markt erhältlich sind. Sie enthalten keine giftigen oder sonst wie umweltbelastenden Substanzen. Es handelt sich um Werkstoffe auf sogenannter Sekundärrohstoffbasis. Insbesondere bei den Metallspänen kann es sich um Abfälle aus metallverarbeitenden Betrieben handeln, die auf diese Weise umweltschonend, d.h. ohne großen Energieaufwand durch Einschmelzen wieder verwendet werden können. Insofern zeichnet sich das erfindungsgemäße Verfahren durch seine Umweltfreundlichkeit aus.

Darüber hinaus ist das Verfahren vergleichsweise einfach in der Anwendung. Die Ausgangsstoffe des Kompositwerkstoffes können separat voneinander bevorratet werden. Zur Herstellung des Kompositwerkstoffes bedarf es lediglich einer Vermischung der Ausgangskomponenten. Anschließend findet eine Verpressung in einer aus dem Stand der Technik an sich bekannten Presse statt, und es steht im Ergebnis ein nach der erfindungsgemäßen Verfahrensdurchführung hergestelltes Formteil. Dieses kann dank einer entsprechenden Wahl hinsichtlich der verwendeten Ausgangskomponenten in unterschiedlichsten Anwendungsfällen zum Einsatz kommen.

Es ist gemäß einem weiteren Merkmal der Erfindung vorgesehen, dass als Metallspäne Späne unterschiedlicher Metalle verwendet werden. Auf diese Weise lässt sich auf die späteren Eigenschaften des nach dem Verfahren hergestellten Formteils gezielt Einfluss nehmen. So kann beispielsweise durch entsprechende Wahl der Menge und der Art der eingesetzten Metallspäne auf die spätere Festigkeit, Wärmeleitfähigkeit, elektrische Leitfähigkeit und/oder dgl. Eigenschaften des späteren Formteils Einfluss genommen werden.

Gemäß einem weiteren Merkmal der Erfindung ist vorgesehen, dass der Kompositwerkstoff unter Verwendung eines Zuschlagstoffes als weitere Ausgangskomponente hergestellt wird. Durch die Verwendung eines Zuschlagstoffes oder sogar mehrerer unterschiedlicher Zuschlagstoffe lassen sich die späteren Eigenschaften des nach dem Verfahren hergestellten Formteils ergänzend beeinflussen. Als ein Zuschlagstoff kommt insbesondere ein hochwärmeleitendes Material in Frage, wie beispielsweise Graphit oder Metallpulver. Es ist so gestattet, dem späteren Formteil eine hohe Wärmeleitfähigkeit zu verleihen, womit es geeignet ist, als Heiz- oder Kühlkörper bzw. als Heiz- oder Kühlkörperteil, als Baukomponente eines Wärmetauschers für Heizung, Kühlung und/oder Klimatisierung oder als Bauelement für den Bau von Wärmetauschern für gasförmige oder flüssige Medien verwendet zu werden. Es können auch andere Zuschlagstoffe gewählt werden, die das nach dem erfindungsgemäßen Verfahren hergestellte Formteil im Besonderen dafür befähigen, im Bauwesen eingesetzt zu werden, beispielsweise als Trägerplatte, Bodenbelag und/oder dgl.

Es ist gemäß einem weiteren Merkmal der Erfindung vorgesehen, dass die Metallspäne vor einer Herstellung des Kompositwerkstoffes zerkleinert werden. Es kann so gezielt auf die Größe der einzelnen Metallspäne Einfluss genommen werden. Auch hierdurch können die späteren Eigenschaften des nach dem erfindungsgemäßen Verfahren hergestellten Formteils gezielt beeinflusst werden.

Der Kompositwerkstoff wird gemäß einem weiteren Merkmal der Erfindung vor einer Verpressung homogenisiert. Diese Maßnahme dient dazu, eine gleichmäßige Verteilung der eingesetzten Ausgangskomponenten innerhalb des Kompositwerkstoffes zu erzielen, so dass das spätere Formteil eine möglichst vergleichmäßigte Eigenschaftsverteilung aufweist.

Es ist gemäß einem weiteren Merkmal der Erfindung vorgesehen, dass in den Kompositwerkstoff während des Verpressens Funktionselemente eingepresst werden. Bei derlei Funktionselementen kann es sich beispielsweise um Befestigungs- und/oder Verbindungselemente handeln, die im späteren Verwendungsfall des erfindungsgemäßen Formteils dazu dienen, Formteile miteinander und/oder mit anderen Baukomponenten dauerhaft sicher koppeln, d.h. verbinden zu können. Als derlei Funktionselemente kommen beispielsweise Haken, Ösen, Anbauteile und/oder dgl. in Frage.

In den Kompositwerkstoff können auch andere Funktionselemente eingebettet werden, wie z.B. Rohre und/oder Rohrregister aus Metall oder Kunststoff. Plattenförmige Formteile mit derart eingebetteten Funktionselementen können als Plattenwärmetauscher-Register oder als Heiz- oder Kühlkörper Verwendung finden. Aus derlei ausgerüsteten Formteilen können auch Wärmetauscher insbesondere, aber nicht nur, Luft-Luft-Wärmetauscher hergestellt werden. Es ist dabei bevorzugt, dass der Kompositwerkstoff Graphit als Zuschlagstoff enthält, der zum Ausfüllen lufthaltender Hohlräume im Kompositwerkstoff dient. Dabei wird im Zuge der erfindungsgemäßen Verfahrensdurchführung die gesamte Oberfläche des Graphits gleichermaßen mit Wasserglas als Klebstoff benetzt. Das Wasserglas wird somit mittelbar mit Graphitteilchen besetzt, um über Silikatbrücken eine Diffusionsverklebung mit den Metalloxiden der Metallspäne einzugehen.

In den Kompositwerkstoff können gemäß einem weiteren Merkmal der Erfindung während des Verpressens Vertiefungen eingepresst werden. Bei derlei Vertiefungen kann es sich beispielsweise um Nuten, Riffelungen und/oder sonstige Oberflächensturen handeln.

Zur Ausbildung eines plattenförmigen Formteils kommen Flächenpressen, Walzenpressen bzw. Kalanderpressen zum Einsatz, in die der Kompositwerkstoff in entsprechender Menge einzubringen ist. In der Flächenpresse können Platten unterschiedlicher Stärke durch Verpressen hergestellt werden.

Je nach späteren Verwendungszweck können weitere Ausgangskomponenten zur Herstellung des Kompositwerkstoffes verwendet werden, so z.B. hochwärmeleitende Materialien, beispielsweise Graphit und/oder Metallpulver. Dabei kommen mit hochwärmeleitendem Material ausgerüstete Formteile vorzugsweise in der Heiz- oder Klimatechnik zum Einsatz, beispielsweise zur Ausgestaltung von Wärmetauschern, Heiz- und/oder Kühleinrichtungen.

Es lassen sich aber auch Formteile mit niedriger Wärmeleitfähigkeit herstellen, die dann beispielsweise in Form von Platten als Konstruktionsmaterial oder Baustoff im Maschinenbau oder im Gebäudebau Verwendung finden können.
In das Formteil können Funktionselemente und/oder Vertiefungen eingebracht sein. Als Funktionselemente kommen insbesondere Befestigungs- und/oder Verbindungselemente, zusätzliche Versteifungselemente und/oder Rohre oder Rohrregister in Frage, die während des Verpressens des Kompositwerkstoffes in diesen eingebettet werden.

Die als Hydrophobierungsmittel der Masse beigemischten Alkoxysilane und/oder Alkoxysiloxane reagieren mit Wassermolekülen des Alkalisilikats (Wasserglases) zu Siliconharz.

Die Alkoxysilane ("Silane") und/oder Alkoxysiloxane ("Siloxane") können in einem organischen Lösungsmittel gelöst oder mittels eines Emulgators als Emulsion in Wasser der Masse beigemischt werden. Die Emulsion kann als niedrigviskose Emulsion (dünnflüssige Mikroemulsion) oder als hochviskose Emulsion (thixotrope Paste) eingestellt werden.
Die Hydrophobierung macht die wärmeleitende Klebe- und Gießmasse wasserabweisend, wodurch ein Eindringen von Wassermolekülen in die Alkalisilikat-Matrix und deren Erweichen verhindert wird.
Weitere Merkmale und Vorteile der Erfindung ergeben sich aus der nachfolgenden Beschreibung anhand der einzigen Figur, die in schematischer Darstellung die erfindungsgemäße Verfahrensdurchführung zeigt.

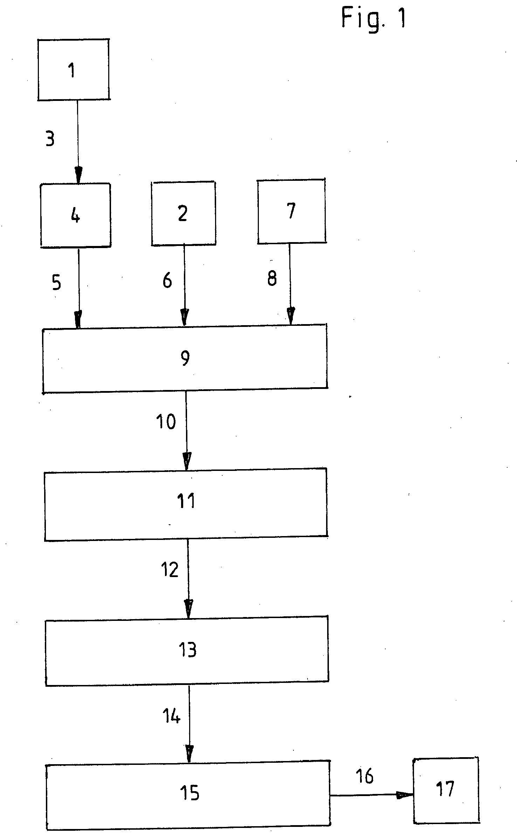

Fig. 1 lässt die erfindungsgemäße Verfahrensdurchführung anhand einer Blockdiagramm-Darstellung schematisch erkennen. Das erfindungsgemäße Formteil 17, das als Ergebnis der Verfahrensdurchführung steht, wird aus einem Kompositwerkstoff, d.h. einem Metallkompositwerkstoff hergestellt. Als Ausgangsstoffe für diesen Kompositwerkstoff dienen Metallspäne 1 sowie Wasserglas 2. Dabei dient das Wasserglas 2 als Klebstoff, das für eine Diffusionsverklebung mit den Oxidschichten der Metallspäne 1 sorgt. Dabei können je nach späterem Verwendungszweck des Formteils 17 Metallspäne unterschiedlicher Metalle zum Einsatz kommen.

Die Metallspäne 1 können vor einer Vermischung mit dem Wasserglas 2 einem Zerkleinerer 4 zugeführt werden. In der Darstellung nach Fig. 1 ist dies durch den Pfeil 3 symbolisiert.

### Bezugszeichen liste

- 1: Metallspäne
- 2: Wasserglas
- 3: Pfeil
- 4: Zerkleinerer
- 5: Pfeil
- 6: Pfeil
- 7: Zuschlagstoff
- 8: Pfeil
- 9: Mischer
- 10: Pfeil
- 11: Homogenisierer
- 12: Pfeil
- 13: Sieb
- 14: Pfeil
- 15: Presse
- 16: Pfeil
- 17: Formteil

## Patentansprüche

1. Verfahren zur Herstellung eines Formteils (17), insbesondere eines plattenförmigen Formteils (17), aus einem Kompositwerkstoff, bei welchem in einem ersten Schritt der Kompositwerkstoff hergestellt wird, indem als Ausgangskomponenten Metallspäne (1) und Wasserglas (2) in einem vorgebbaren Mischungsverhältnis miteinander vermischt werden; bei welchem in einem zweiten Schritt der Kompositwerkstoff in eine Pressform eingebracht wird; und bei welchem in einem dritten Schritt der Kompositwerkstoff verpresst wird, wobei dem Kompositwerkstoff ein Hydrophobierungsmittel beigemischt wird, welches eine siliciumorganische Verbindung
aus der Gruppe Silane oder Siloxane aufweist.

2. Verfahren nach Anspruch 1, **dadurch gekennzeichnet, dass** als Metallspäne Späne unterschiedlicher Metalle verwendet werden.

3. Verfahren nach Anspruch 1 oder 2, **dadurch gekennzeichnet, dass** der Kompositwerkstoff unter Verwendung eines Zuschlagstoffes als weitere Ausgangskomponente hergestellt wird.

4. Verfahren nach Anspruch 3, **dadurch gekennzeichnet, dass** der Kompositwerkstoff unter Verwendung eines hochwärmeleitenden Materials, vorzugsweise Graphit und/oder Metallpulver als weitere Ausgangskomponente hergestellt wird.

5. Verfahren nach einem der vorhergehenden Ansprüche, **dadurch gekennzeichnet, dass** die Metallspäne (1) vor einer Herstellung des Kompositwerkstoffes zerkleinert werden.

6. Verfahren nach einem der vorhergehenden Ansprüche, **dadurch gekennzeichnet, dass** der Kompositwerkstoff vor einer Verpressung homogenisiert wird.

7. Verfahren nach einem der vorhergehenden Ansprüche, **dadurch gekennzeichnet, dass** in den Kompositwerkstoff während des Verpressens Funktionselemente eingepresst werden.

8. Verfahren nach einem der vorhergehenden Ansprüche, **dadurch gekennzeichnet, dass** in den Kompositwerkstoff während des Verpressens Vertiefungen eingepresst werden.

## Claims

1. A method for producing a moulded part (17), in particular a plate-shaped moulded part (17), from a composite material, in which in a first step the composite material is produced by mixing metal chips (1) and water glass (2) as starting components with each other in a pre-determinable mixing ratio; in which in a second step the composite material is introduced into a press mould and in which in a third step the composite material is pressed, wherein a water-repellent agent is added to the composite material, which water-repellent agent comprises a silicon-organic compound of the group containing silanes or siloxanes.

2. A method according to claim 1, **characterized in that** chips of different metals will be used as metal chips.

3. A method according to claim 1 or 2, **characterized in that** the composite material will be produced as a further starting component by using an aggregate.

4. A method according to claim 3, **characterized in that** the composite material will be produced by using a highly heat-conducting material, preferably graphite and/or metal powder as a further starting component.

5. A method according to one of the preceding claims, **characterized in that** the metal chips (1) will be crushed before producing the composite material.

6. A method according to one of the preceding claims, **characterized in that** the composite material will be homogenized before being pressed.

7. A method according to one of the preceding claims, **characterized in that** the functional elements will be pressed into the composite material during the pressing operation.

8. A method according to one of the preceding claims, **characterized in that** indentations will be pressed into the composite material during the pressing operation.

## Revendications

1. Procédé de fabrication d'une pièce moulée (17), notamment d'une pièce moulée en forme de plaque (17), à partir d'un matériau composite, dans lequel dans une première étape le matériau composite est fabriqué en mélangeant des copeaux métalliques (1) et du verre soluble (2) comme des composants d'origine les uns avec l'autre dans un rapport de mélange pré-déterminable, dans lequel dans une deuxième étape le matériau composite est introduit dans une moule ; et dans lequel dans une troisième étape le matériau composite est pressé, un agent rendant hydrophobe étant ajouté au matériau composite, lequel agent rendant hydrophobe comprend un composé organosilicié du groupe composé de silanes ou de siloxanes.

2. Procédé selon la revendication 1, **caractérisé en ce que** des copeaux de métaux différents sont utilisés comme des copeaux métalliques.

3. Procédé selon la revendication 1 ou la revendication 2, **caractérisé en ce que** le matériau composite est fabriqué en utilisant un agrégat comme une autre composant d'origine.

4. Procédé selon la revendication 3, **caractérisé en ce que** le matériau composite est fabriqué en utilisant un matériau fortement conducteur thermique, de préférence du graphite et/ou du poudre métallique comme une autre composant d'origine.

5. Procédé selon l'une des revendications précédentes, **caractérisé en ce que** les copeaux métalliques (1) sont broyés avant une fabrication du matériau composite.

6. Procédé selon l'une des revendications précédentes, **caractérisé en ce que** le matériau composite est homogénéisé avant l'opération de pressage.

7. Procédé selon l'une des revendications précédentes, **caractérisé en ce que** des éléments fonctionnels sont pressés dans le matériau composite lors de l'opération de pressage.

8. Procédé selon l'une des revendications précédentes, **caractérisé en ce que** des cavités sont pressées dans le matériau composite lors de l'opération de pressage.
